# FASCICULE DE BREVET EUROPEEN

(11) **EP 3 136 115 B1**
(45) Date de publication et mention de la délivrance du brevet: **23.11.2022**
(21) Numéro de dépôt: 16183470.0
(22) Date de dépôt: 09.08.2016
(51) Int. Cl.: B60L 3/04, B60L 3/12, G01R 31/52, G01R 27/18, B60L 3/00, G01R 31/00

(54) **SYSTÈME ÉLECTRIQUE COMPORTANT UN DISPOSITIF D'ÉVALUATION D'UN DÉFAUT D'ISOLATION, VÉHICULE AUTOMOBILE COMPORTANT UN TEL SYSTÈME ÉLECTRIQUE**
ELEKTRISCHES SYSTEM, DAS EINE AUSWERTEVORRICHTUNG EINES ISOLATIONSFEHLERS UMFASST UND EIN SOLCHES ELEKTRISCHES SYSTEM UMFASSENDES KRAFTFAHRZEUG
ELECTRICAL SYSTEM INCLUDING A DEVICE FOR ASSESSING AN INSULATION FAULT AND MOTOR VEHICLE COMPRISING SUCH AN ELECTRICAL SYSTEM

(30) Priorité: 26.08.2015 FR 1557939
(43) Date de publication de la demande: 01.03.2017
(73) Titulaire: Valeo eAutomotive France SAS, 95800 Cergy (FR)
(72) Inventeur: OSWALD, Dominique, 78800 HOUILLES (FR)
(74) Mandataire: Valeo Powertrain Systems

(56) Documents cités:
- EP-A1- 2 854 269
- EP-A1- 2 869 075
- DE-A1- 10 355 086
- FR-A1- 3 011 636
- US-A1- 2012 126 839
- US-A1- 2014 097 854

## Description

### DOMAINE TECHNIQUE

La présente invention concerne le domaine de l'évaluation d'un défaut d'isolation entre un circuit électrique et une masse électrique.

### ARRIÈRE-PLAN TECHNOLOGIQUE

On connait déjà de l'état de la technique un système électrique comportant :
- un circuit électrique présentant un point d'entrée de phase et un point d'entrée de neutre entre lesquels une tension de réseau, fournie par un réseau électrique, est destinée à être appliquée pour alimenter électriquement le circuit électrique,
- une masse électrique,
- un dispositif d'évaluation d'un défaut d'isolation entre le circuit électrique et la masse électrique.

Des exemples de l'état de la technique peuvent être vus dans US 2014/097854 Al, divulguant un appareil et un procédé pour surveiller une isolation d'un réseau électrique non mis à la terre, notamment dans un système photovoltaïque, ou dans US 2012/126839 Al, divulguant un procédé de surveillance d'isolement dans un circuit convertisseur dans un réseau de tension continue et/ou alternative non mis à la terre pour le fonctionnement dynamique d'un moteur à courant alternatif ou continu dans un véhicule à moteur hybride et un véhicule à moteur électrique.

Dans le domaine automobile, le système électrique est par exemple intégré dans un véhicule automobile et le circuit électrique comporte une batterie et un redresseur de tension connecté, d'un côté, aux points d'entrée de phase et de neutre du circuit électrique et, d'un autre côté, à la batterie, pour recharger la batterie à partir du réseau électrique. Dans ce cadre, le dispositif d'évaluation est généralement compris dans le système de gestion de batterie (en anglais : Battery Managment System, ou BMS). Le véhicule automobile est alors destiné à arrêter à des instants aléatoires la charge de la batterie pour demander au système de gestion de batterie de vérifier l'impédance entre le circuit électrique et la masse électrique. Cette vérification est donc réalisée à partir de la tension de batterie, générant au travers du défaut d'isolation un courant de fuite continu.

Cette solution présente comme inconvénient de nécessiter d'arrêter la charge pour évaluer le défaut d'isolation. En outre, elle ne permet que d'évaluer les défauts d'isolation se trouvant uniquement, par rapport au redresseur, du côté de la batterie.

L'invention a pour but de proposer un dispositif alternatif pour évaluer un défaut d'isolation entre un circuit électrique et une masse électrique.

### RÉSUMÉ DE L'INVENTION

À cet effet, il est proposé un système électrique comportant :
- un circuit électrique présentant au moins un point d'entrée de phase et un point d'entrée de neutre, une tension de réseau d'un réseau électrique étant destinée à être appliquée entre chaque point d'entrée de phase et le point d'entrée de neutre pour alimenter électriquement le circuit électrique,
- une masse électrique,
- un dispositif d'évaluation d'un défaut d'isolation entre le circuit électrique et la masse électrique, ledit dispositif (172) d'évaluation d'un défaut d'isolation (152) comportant:
   - un dispositif de mesure d'un premier courant de mode commun entrant dans le circuit électrique par son ou ses points d'entrée de phase et son point de neutre et rebouclant par la masse électrique, en particulier au travers du défaut d'isolation, le premier courant de mode commun étant fourni par un générateur électrique,
   - un dispositif de mesure d'une tension fournie par le générateur électrique,
   - un dispositif de multiplication de la mesure du premier courant de mode commun par la mesure de la tension pour obtenir une puissance développée par le générateur électrique pour fournir le premier courant de mode commun,
   - un dispositif de détermination d'une partie active de la puissance,
   - un dispositif de détermination d'au moins une grandeur électrique représentative du défaut d'isolation, à partir de la partie active de la puissance,
ledit système électrique comportant en outre :
- au moins un conducteur de phase et un conducteur de neutre présentant des premières extrémités connectées respectivement aux points d'entrée de phase et de neutre du circuit électrique, et des deuxièmes extrémités destinées à être connectées respectivement à au moins une borne de phase et une borne de neutre du réseau électrique,
caractérisé en ce que ledit système électrique comprend en outre :
- un dispositif d'annulation d'un deuxième courant de mode commun entrant dans les conducteurs de phase et de neutre par leurs deuxièmes extrémités, comportant :
   - un dispositif de mesure du deuxième courant de mode commun,
   - un générateur, à partir de la mesure du deuxième courant de mode commun, d'un courant de compensation s'écoulant depuis la masse électrique vers les conducteurs de phase et de neutre, et étant sensiblement égal au premier courant de mode commun,
et le générateur du courant de compensation est le générateur électrique du dispositif d'évaluation du défaut d'isolation.

De façon optionnelle également, le dispositif de mesure du premier courant de mode commun est destiné à mesurer le courant de compensation en tant que mesure du premier courant de mode commun.

De façon optionnelle également, le dispositif de mesure de la tension générée par le générateur électrique est destiné à mesurer, en tant que mesure de la tension générée par le générateur électrique, la tension de réseau entre le conducteur de phase et le conducteur de neutre.

De façon optionnelle également, le dispositif de mesure de la tension générée par le générateur électrique est destiné à mesurer une tension de compensation fournie par le générateur du courant de compensation.

De façon optionnelle également, le générateur électrique est le réseau électrique.

De façon optionnelle également, le dispositif de mesure du premier courant de mode commun est destiné à mesurer le premier courant de mode commun à partir des conducteurs de phase et de neutre.

De façon optionnelle également, le réseau électrique est monophasé et le dispositif de mesure de la tension générée par le générateur électrique est destiné à mesurer la tension de réseau entre le conducteur de phase et le conducteur de neutre.

De façon optionnelle également, le système électrique comporte en outre le générateur électrique, et le générateur électrique est un générateur de courant destiné à générer le premier courant de mode commun.

De façon optionnelle également, le système électrique comporte en outre :
- u moins un conducteur de phase et un conducteur de neutre présentant des premières extrémités connectées respectivement au ou aux points d'entrée de phase et au point d'entrée de neutre du circuit électrique, et des deuxièmes extrémités destinées à être connectées respectivement à au moins une borne de phase et une borne de neutre du réseau électrique,
et le dispositif d'évaluation du défaut d'isolation comporte en outre :
- un dispositif pour injecter le premier courant de mode commun dans les conducteurs de phase et de neutre, en direction des points d'entrée de phase et de neutre du circuit électrique.

De façon optionnelle également, le dispositif pour injecter le premier courant de mode commun dans les conducteurs de phase et de neutre, comporte :
- un filtre de mode commun comportant au moins deux inductances de filtrage montées respectivement sur les conducteurs de phase et de neutre, la ou les inductances de filtrage montées sur le ou les conducteurs de phase étant couplées avec l'inductance de filtrage montée sur le conducteur de neutre,
- une inductance d'injection couplée à au moins une des inductances de filtrage, et présentant une première extrémité connectée au générateur du courant de mode commun,
- deux capacités connectant une deuxième extrémité de l'inductance d'injection respectivement aux conducteurs de phase et de neutre.

De façon optionnelle également, le circuit électrique comporte :
- une batterie comportant une borne positive et une borne négative et présentant une tension de batterie entre ses bornes positive et négative, et
- un redresseur de tension connecté, d'un côté, aux points d'entrée de phase et de neutre du circuit électrique et, d'un autre côté, aux bornes positive et négative de la batterie, le redresseur de tension étant destiné à convertir la tension de réseau en la tension de batterie, pour recharger la batterie à partir du réseau électrique.

Il est également proposé un véhicule automobile comportant un système électrique selon l'invention, dans lequel la masse électrique comporte un châssis du véhicule automobile, et dans lequel la batterie est destinée à alimenter électriquement des organes électriques du véhicule automobile et/ou un moteur d'entraînement de roues motrices du véhicule automobile.

Il est également proposé un procédé d'évaluation d'un défaut d'isolation entre un circuit électrique et une masse électrique, comportant :
- la mesure d'un premier courant de mode commun entrant dans le circuit électrique par des points d'entrée de phase et de neutre du circuit électrique et rebouclant par la masse électrique, en particulier au travers du défaut d'isolation, le premier courant de mode commun étant fourni par un générateur électrique,
- la mesure d'une tension fournie par le générateur électrique,
- la multiplication de la mesure du premier courant de mode commun par la mesure de la tension pour obtenir une puissance développée par le générateur électrique pour fournir le premier courant de mode commun,
- la détermination d'une partie active de la puissance,
- la détermination d'au moins une grandeur électrique représentative du défaut d'isolation, à partir de la partie active de la puissance.

### DESCRIPTION DES FIGURES

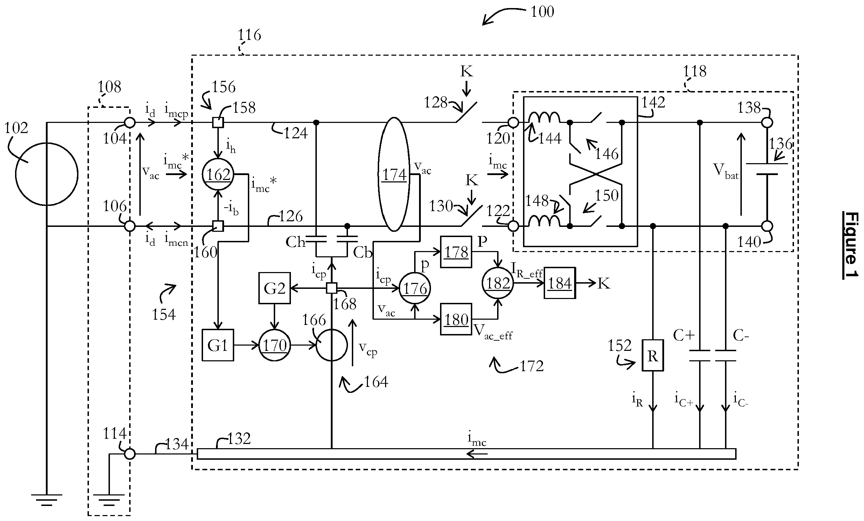

Les figures 1 à 5 sont des schémas électriques représentant respectivement cinq modes de réalisation d'une installation selon l'invention, de recharge d'un véhicule automobile.

### DESCRIPTION DÉTAILLÉE

En référence à la figure 1, une première installation de recharge 100 selon l'invention va à présent être décrite.

L'installation de recharge 100 comporte tout d'abord un réseau électrique 102 présentant une borne de phase 104 et une borne de neutre 106 entre lesquelles le réseau électrique 102 génère une tension de réseau v_{ac} alternative. La borne de neutre 106 du réseau électrique 102 est connecté à la terre. Les bornes de phase 104 et de neutre 106 sont situées dans une station de recharge 108. Par ailleurs, la station de recharge 108 comporte une borne de terre 114 connectée à la terre.

L'installation de recharge 100 comporte en outre un véhicule automobile électrique (non représenté), comportant un système électrique 116 qui va à présent être décrit.

Le système électrique 116 comporte tout d'abord un circuit électrique 118 présentant un point d'entrée de phase 120 et un point d'entrée de neutre 122 entre lesquels la tension de réseau v_{ac} est destinée à être appliquée pour alimenter électriquement le circuit électrique 118.

Le système électrique 116 comporte en outre un conducteur de phase 124 et un conducteur de neutre 126 présentant des premières extrémités connectées respectivement aux points d'entrée de phase et de neutre 120, 122 du circuit électrique 118, et des deuxièmes extrémités destinées à être connectées respectivement aux bornes de phase 104 et de neutre 106 du réseau électrique 102. Les conducteurs de phase 124 et de neutre 126 comportent par ailleurs respectivement un interrupteur de phase 128 et un interrupteur de neutre 130 destinés à sélectivement connecter et déconnecter le circuit électrique 118 du réseau électrique 102. Les interrupteurs 128, 130 sont fermés par défaut.

Le système électrique 116 comporte en outre une masse électrique 132. Dans l'exemple décrit, la masse électrique 132 comporte un châssis du véhicule automobile.

Le système électrique 116 comporte en outre un conducteur de terre 134 présentant une première extrémité connectée à la masse électrique 132 et une deuxième extrémité destinée à être connectée à la borne de terre 114 de la station de recharge pour connecter la masse électrique 132 à la terre.

Les conducteurs de phase 124, de neutre 126 et de terre 134 sont de préférence regroupés, au niveau de leurs deuxièmes extrémités, dans un câble (non représenté) destiné à être branché à la station de recharge 108 pour connecter les deuxièmes extrémités des conducteurs de phase 124, de neutre 126 et de terre 134 à leurs bornes 104, 106, 114 respectives de la station de recharge 108.

Dans l'exemple décrit, le circuit électrique 118 comporte tout d'abord une batterie 136 comportant une borne positive 138 et une borne négative 140 et présentant une tension de batterie V_{bat} entre ces bornes 138, 140. La batterie 136 est par exemple destinée à alimenter électriquement des organes électriques du véhicule automobile et/ou un moteur d'entraînement de roues motrices du véhicule automobile.

Le circuit électrique 118 comporte en outre un redresseur de tension 142 connecté, d'un côté, aux points d'entrée de phase 120 et de neutre 122 du circuit électrique 118 et, d'un autre côté, aux bornes positive 138 et négative 140 de la batterie 136. Le redresseur de tension 142 est destiné à convertir la tension de réseau v_{ac} en la tension de batterie V_{bat} pour permettre la recharge de la batterie 136 à partir du réseau électrique 102.

Le redresseur de tension 142 comporte une inductance de phase 144 présentant une première extrémité connectée au conducteur de phase 124 et un bras de commutation de phase 146 destiné à sélectivement connecter et déconnecter une deuxième extrémité de l'inductance de phase 144 respectivement aux bornes positive 138 et négative 140 de la batterie 136. Le bras de commutation de phase 146 comporte par exemple deux interrupteurs connectés ensemble, ainsi qu'à la deuxième extrémité de l'inductance de phase 144, en un point milieu. De manière similaire, le redresseur de tension 142 comporte une inductance de neutre 148 et un bras de commutation de neutre 150.

Par ailleurs, le système électrique 116 comporte une ou plusieurs capacités de filtrage électromagnétique connectant respectivement différents points du circuit électrique 118 à la masse électrique 132. Dans l'exemple décrit, le système électrique 116 comporte une capacité de filtrage électromagnétique C+ connectant la borne positive 138 de la batterie 136 à la masse électrique 132 et une capacité de filtrage électromagnétique C- connectant la borne négative 140 de la batterie 136 à la masse électrique 132.

Par ailleurs, un défaut d'isolation 152 peut être présent entre le circuit électrique 118 et la masse électrique 132. Ce défaut d'isolation 152 correspond à la présence d'une ou plusieurs résistances non infinies chacune entre un point respectif du circuit électrique 118 et la masse électrique 132. Le défaut d'isolation 152 peut par exemple comporter des résistances parasites inhérentes aux capacités de filtrage électromagnétique. Le défaut d'isolation 152 peut en outre comporter un chemin de faible résistance reliant le circuit électrique 118 et la masse électrique 132. Ce chemin parasite de faible résistance peut par exemple être dû à une infiltration d'eau. Dans l'exemple décrit, le défaut d'isolation 152 est représenté par une résistance R entre la borne négative 140 de la batterie 136 et la masse électrique 132.

Ces différentes connexions résistives et capacitives sont soumises chacune à une différence de potentiels entre le potentiel de la masse électrique 132 (égal à zéro par convention) et le potentiel du point auquel la connexion est connectée. Ce dernier potentiel dépend de la tension de réseau v_{ac} et, éventuellement, de la tension de batterie V_{bat}. Par exemple, la borne négative 140 de la batterie 136 est en moyenne au potentiel : v_{ac}/2 - V_{bat}/2. Ainsi, un courant peut s'écouler dans ces différentes connexions, ces courant formant ensemble un courant de mode commun i_{mc} s'écoulant depuis le circuit électrique 118 vers la masse électrique 132.

Dans l'exemple décrit, le courant de mode commun i_{mc} est égal à la somme d'un courant de défaut d'isolation i_{R} passant au travers de la résistance R et d'un courant capacitif i_{C} passant par les capacités de filtrage électromagnétique C+, C-.

De manière générale, le courant de mode commun i_{mc} comporte une partie continue (provenant de la tension de batterie V_{bat} appliquée à une résistance), une partie alternative en phase avec le réseau électrique 102 (provenant de la tension de réseau v_{ac} appliquée à une résistance) et une partie alternative en quadrature de phase avec le réseau électrique 102 (provenant de la tension de réseau v_{ac} appliquée à une capacité).

Le courant de mode commun i_{mc} reboucle à partir de la masse électrique 132 en suivant le chemin : conducteur de neutre 126, terre, réseau électrique 102 et conducteurs de phase 124 et de neutre 126 pour entrer dans le circuit électrique 118 par ses point d'entrée de phase 120 et de neutre 122. Le courant de mode commun i_{mc} sort ainsi du réseau électrique 102 et vient se superposer à un courant différentiel i_{d} se propageant du réseau électrique 102 au circuit électrique 118 au travers du conducteur de phase 124, et rebouclant du circuit électrique 118 au réseau électrique 102 par le conducteur de neutre 122. Le courant de mode commun i_{mc} se divise donc entre un courant de mode commun de phase i_{mcp} passant par le conducteur de phase 124 et un courant de mode commun de neutre i_{mcn} passant par le conducteur de neutre 126.

Si le courant de mode commun i_{mc} devient trop important, il risque de déclencher un disjoncteur (non représenté) prévu dans la station de recharge 108.

Par la suite, on distinguera, d'une part, le courant de mode commun, noté i_{mc}, entrant dans le circuit électrique 118 par ses points d'entrée 120, 122 et, d'autre part, le courant de mode commun, noté i_{mc}^{∗}, entrant dans les conducteurs 124, 126 par leurs deuxièmes extrémités, c'est-à-dire le courant de mode commun i_{mc}^{∗} provenant du réseau électrique 102.

Pour éviter en particulier les déclenchements intempestifs du disjoncteur de la station de recharge 108, le système électrique 116 comporte un dispositif 154 d'annulation du courant de mode commun i_{mc}^{∗} provenant du réseau électrique 102.

Le dispositif 154 comporte tout d'abord un dispositif 156 de mesure du courant de mode commun i_{mc}^{∗}. Dans l'exemple décrit, le dispositif 156 est destiné à mesurer le courant de mode commun i_{mc}^{∗} à partir des conducteurs de phase 124 et de neutre 126. Plus précisément, le dispositif 156 comporte tout d'abord un premier ampèremètre 158 monté sur le conducteur de phase 124 et destiné à mesurer le courant passant dans le conducteur de phase 124, par exemple en direction du circuit électrique 118, c'est-à-dire le courant i_{d} + i_{mcp}. Le dispositif 156 comporte en outre un deuxième ampèremètre 160 monté sur le conducteur de neutre 126 et destiné à mesurer le courant passant dans le conducteur de neutre 124, par exemple en direction de la station de recharge 108, c'est-à-dire le courant i_{d} - i_{mcn}. Le dispositif 156 comporte en outre un dispositif 162 pour déterminer le courant de mode commun i_{mc}^{∗} à partir des mesures des ampèremètres 158, 160, par exemple par soustraction de leurs mesures : i_{d} + i_{mcp} - (i_{d} - i_{mcn}) = i_{mcp} + i_{mcn} = i_{mc}^{∗}. Alternativement, le dispositif de mesure du courant de mode commun i_{mc}^{∗} pourrait être destiné à mesurer le courant de mode commun i_{mc}^{∗} à partir du conducteur de terre 134.

Le dispositif 154 comporte en outre un générateur 164 d'un courant de compensation i_{cp} s'écoulant depuis la masse électrique 132 vers les conducteurs de phase 124 et de neutre 126. Le courant de mode commun i_{mc} est donc égal à la somme du courant de mode commun i_{mc}^{∗} et du courant de compensation i_{cp}, soit : i_{mc} = i_{mc}^{∗} + i_{cp}. Le courant de compensation i_{cp} est généré à partir de la mesure du courant de mode commun i_{mc}^{∗} de manière à diminuer le courant de mode commun i_{mc}^{∗}, jusqu'à sensiblement l'annuler. Autrement dit, le générateur 164 force le courant de mode commun i_{mc} à reboucler vers les conducteurs de phase 124 et de neutre 126 avant de passer par le réseau électrique 102. Ainsi, lorsque le courant de mode commun i_{mc}^{∗} est sensiblement nul grâce au dispositif 154, le courant de compensation i_{cp} est sensiblement égal au courant de mode commun i_{mc}.

Dans l'exemple décrit, le générateur 164 comporte tout d'abord un générateur 166 d'une tension de compensation v_{cp}, dont une extrémité est connectée à la masse électrique 132. Le générateur 164 comporte en outre deux capacités Ch, Cb connectant une deuxième extrémité du générateur 166 respectivement au conducteur de phase 124 et au conducteur de neutre 126. Le générateur 166 fournit le courant de compensation i_{cp} qui passe au travers des capacités Ch, Cb pour atteindre les conducteurs de phase 124 et de neutre 126.

Le générateur 164 comporte en outre un ampèremètre 168 monté sur une extrémité du générateur 166, par exemple sur sa deuxième extrémité. L'ampèremètre 168 est destiné à fournir une mesure du courant de compensation i_{cp}.

Le générateur 164 comporte en outre un gain G1 destiné à être appliqué à la mesure du courant de mode commun i_{mc}^{∗} et un gain G2 destiné à être appliqué à la mesure du courant de compensation i_{cp}.

Le générateur 164 comporte en outre un dispositif 170 destiné à combiner les sorties des gains G1, G2 pour commander la tension de compensation v_{cp}. Dans l'exemple décrit le dispositif 170 est destiné à additionner les sorties des gains G1, G2, de sorte que : v_{cp} = G1 x i_{mc}^{∗} + G2 x i_{cp}.

Ainsi, le dispositif 154 permet de diminuer le courant de mode commun i_{mc}^{∗} sans nécessiter de corriger l'isolation entre le circuit électrique 118 et la masse électrique 132, et donc sans nécessiter d'intervention sur le véhicule automobile.

Le dispositif 154 est décrit plus en détail dans la demande de brevet européen publiée sous le numéro EP 2 854 269 A1.

Par ailleurs, il peut être utile d'évaluer le défaut d'isolation 152. Par exemple, si ce défaut d'isolation 152 devient trop important, la station de recharge 108 ne sera pas capable de le détecter à cause du dispositif 154 d'annulation du courant de mode commun i_{mc}^{∗}.

Ainsi, le système électrique 116 comporte en outre un dispositif 172 d'évaluation du défaut d'isolation 152.

Le dispositif 172 comporte tout d'abord un dispositif de mesure du courant de compensation i_{cp} fourni par le générateur 164. Dans l'exemple décrit, l'ampèremètre 168 du dispositif 154 d'annulation du courant de mode commun i_{mc}^{∗} est utilisé comme dispositif de mesure du courant de compensation i_{cp}.

Le dispositif 172 comporte en outre un dispositif 174 de mesure de la tension v_{ac}. Dans l'exemple décrit, ce dispositif 174 comporte un voltmètre disposé entre les conducteurs de phase 124 et de neutre 126.

Le dispositif 172 comporte en outre un dispositif 176 de détermination d'une puissance p correspondant à la puissance développée par le générateur 164 pour fournir le courant de mode commun i_{mc} (puisque le courant de compensation i_{cp} est sensiblement égal au courant de mode commun i_{mc}. La puissance p correspond donc également à la puissance qui serait développée par le réseau électrique 102 pour fournir le courant de mode commun i_{mc}, en l'absence du dispositif 154 d'annulation du courant de mode commun i_{mc}^{∗}. La puissance p est en théorie obtenue par la multiplication du courant de compensation i_{cp} par la tension de compensation v_{cp}. Cependant, comme la tension de réseau v_{ac} est sensiblement égale à la tension de compensation v_{cp}, le dispositif 172 est destiné à multiplier la mesure du courant de compensation i_{cp} par la mesure de la tension v_{ac} pour déterminer la puissance p.

Le dispositif 172 comporte en outre un dispositif 178 de détermination d'une partie active P de la puissance p, correspondant à la puissance dissipée par effet résistif et représentant donc la contribution de la résistance R du défaut d'isolation 152. La puissance active est la moyenne de la puissance p.

Le dispositif 172 comporte en outre un dispositif 180 de fourniture d'une amplitude de la tension de compensation v_{cp}, par exemple l'une parmi : l'amplitude de crête, l'amplitude crête à crête et, de préférence, l'amplitude efficace. Comme la tension de réseau v_{ac} est sensiblement égale à la tension de compensation v_{cp}, une amplitude de la tension de réseau v_{ac} est utilisée en tant qu'amplitude de la tension de compensation v_{cp}. Dans l'exemple décrit, l'amplitude efficace V_{ac_eff} de la tension réseau v_{ac} est utilisée et déterminée à partir de la mesure de la tension de réseau v_{ac} réalisée par le dispositif 174. Alternativement, l'amplitude de la tension de compensation v_{cp} pourrait être simplement prédéfinie et enregistrée dans une mémoire. Cette solution peut être intéressante si le véhicule automobile est destiné à n'être rechargé que sur un même type de réseau électrique présentant toujours sensiblement la même valeur efficace. Par exemple, le réseau électrique européen présente une amplitude efficace de 230 V. Ainsi, la valeur de 230 V pourrait être enregistrée dans une mémoire, et récupérer par le dispositif 180 pour la fournir.

Le dispositif 172 comporte en outre un dispositif 182 de détermination, à partir de la partie active P de la puissance p et de l'amplitude de la tension de réseau v_{ac} (prise comme amplitude de la tension de compensation v_{cp}), d'au moins une grandeur électrique représentative du défaut d'isolation 152. Dans l'exemple décrit, le dispositif 182 est destiné à diviser la partie active P de la puissance p par l'amplitude de la tension de réseau v_{ac} pour obtenir une amplitude du courant i_{R} du défaut d'isolation 152, par exemple l'une parmi : l'amplitude de crête, l'amplitude de crête à crête et, de préférence, l'amplitude efficace. Dans l'exemple décrit où l'amplitude efficace V_{ac_eff} de la tension de réseau v_{ac} est utilisée, la grandeur électrique obtenue est donc l'amplitude efficace I_{R_eff} du courant i_{R} du défaut d'isolation 152 : I_{R_eff} = P/V_{ac_eff}.

Le dispositif 172 d'évaluation du défaut d'isolation 152 comporte en outre un dispositif 184 de détermination d'une commande K pour les interrupteurs 128, 130 en fonction de la grandeur électrique déterminée. Par exemple, le dispositif 184 est destiné à fournir une commande K d'ouverture des interrupteurs 128, 130 lorsque l'amplitude du courant i_{R} dépasse un certain seuil, ce qui permet de déconnecter le circuit électrique 118 du réseau électrique 102.

Ainsi, le dispositif 172 permet d'isoler, dans le courant de mode commun, la partie résistive résultant en particulier des connexions résistives entre le circuit électrique 118 et la masse électrique 132, de la partie capacité « normale » résultant des connexions capacitives souhaitées entre le circuit électrique 118 et la masse électrique 132.

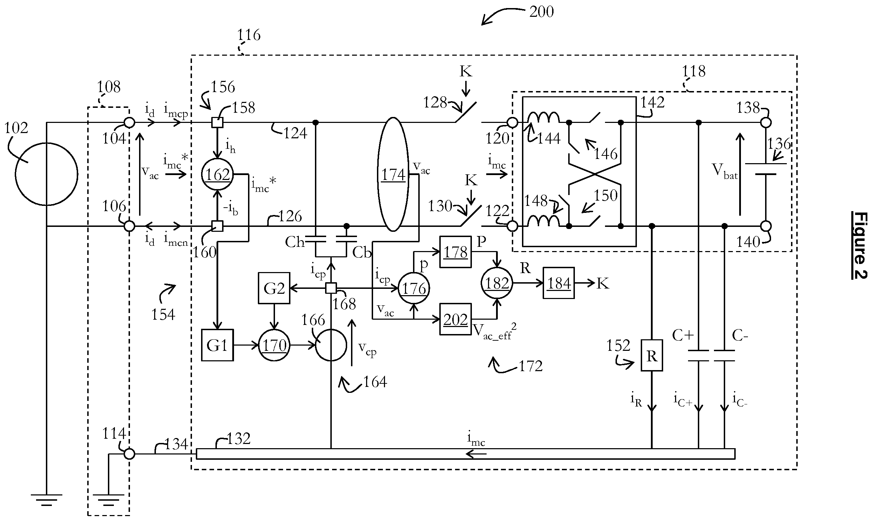

En référence à la figure 2, une deuxième installation de recharge 200 selon l'invention va à présent être décrite.

La deuxième installation de recharge 200 est identique à celle de la figure 1, si ce n'est pour les différences suivantes.

Le dispositif 180 est remplacé par un dispositif 202 de fourniture d'une amplitude au carré de la tension de réseau v_{ac}. Dans l'exemple décrit, le dispositif 202 fournit l'amplitude efficace au carré V_{R_eff}², qui est déterminée à partir de la mesure de la tension de réseau v_{ac}. Comme dans le mode de réalisation de la figure 1, l'amplitude pourrait être simplement prédéfinie et enregistrée dans une mémoire.

Par ailleurs, le dispositif 182 est destiné à déterminer la grandeur électrique à partir de la partie active P de la puissance p et, cette fois, de l'amplitude au carré de la tension de réseau v_{ac}. Dans l'exemple décrit, le dispositif 182 est destiné à diviser l'amplitude efficace au carré V_{ac_eff}² par la partie active P de la puissance p. Ainsi, la grandeur électrique obtenue est la résistance R : R = V_{ac_eff}²/P. La résistance R correspond donc à la résistance « vue » par le générateur 164. Il s'agit également de la résistance que verrait le réseau électrique 102 en l'absence du dispositif 154 d'annulation du courant de mode commun i_{mc}^{∗}.

Comme expliqué précédemment, une résistance R non infinie peut être présente même en l'absence d'un chemin parasite de faible résistance, du fait par exemple des résistances parasites des capacités de filtrage électromagnétique. Ainsi, la valeur absolue de la résistance R n'est pas obligatoirement un bon indicateur de la présence d'un tel chemin parasite.

Ainsi, plutôt que de s'intéresser à la valeur absolue de la résistance R, le dispositif 184 peut être configuré pour déterminer la variation au cours du temps de la résistance R, afin de déterminer l'apparition d'un défaut d'isolation à partir de cette variation, par exemple lorsque la résistance R diminue fortement. Le dispositif 184 peut alors être configuré pour provoquer, en plus ou à la place de la commande K pour les interrupteurs 128, 130, l'envoi d'un signal d'avertissement (par exemple, visuel et/ou sonore) à destination de l'utilisateur pour lui indiquer qu'une révision de l'isolation entre le circuit électrique 118 et la masse électrique 132 est nécessaire.

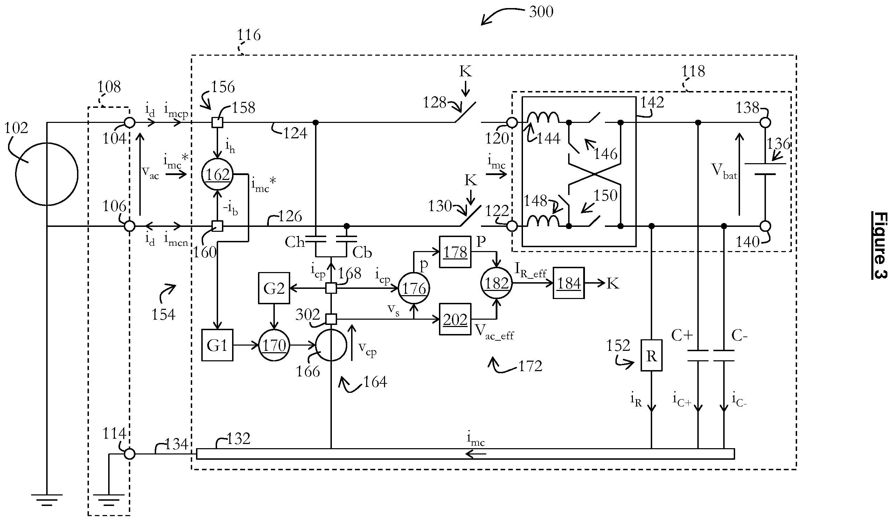

En référence à la figure 3, une troisième installation de recharge 300 selon l'invention va à présent être décrite.

La troisième installation de recharge 300 est similaire à celle de la figure 1, si ce n'est que le dispositif de mesure de la tension de compensation v_{cp}, désigné cette fois par la référence 302, est destiné à mesurer la tension de compensation v_{cp} telle qu'elle apparaît entre les extrémités du générateur 164. Par exemple, le dispositif 302 comporte un voltmètre disposé entre les extrémités du générateur 164, c'est-à-dire dans l'exemple décrit entre les extrémités du générateur de tension 166.

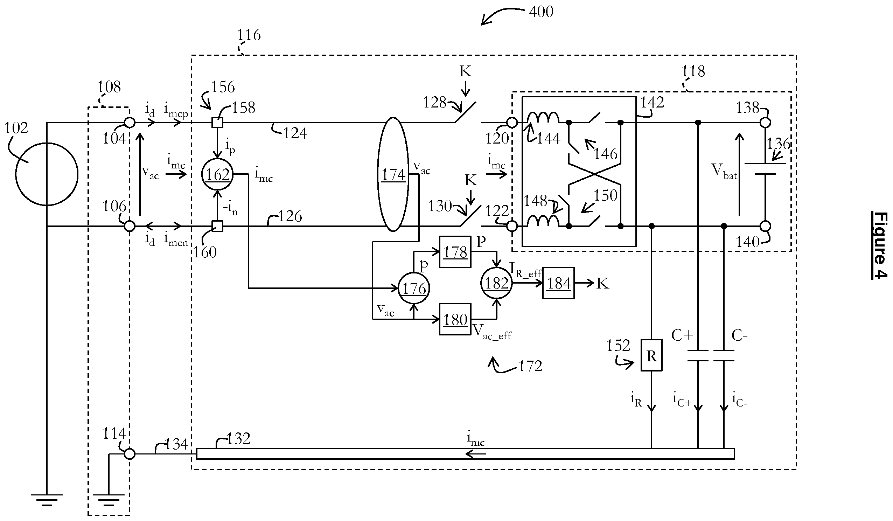

En référence à la figure 4, une quatrième installation 400 de recharge selon l'invention va à présent être décrite.

La quatrième installation de recharge 400 est similaire à celle de la figure 1, si ce n'est qu'elle ne comporte pas le dispositif 154 d'annulation du courant de mode commun i_{mc}^{∗}. Ainsi, dans ce cas, les courants de mode commun i_{mc}^{∗} et i_{mc} sont égaux, et sont notés i_{mc}.

Dans ce mode de réalisation, le dispositif de mesure du courant de mode commun i_{mc} est similaire au dispositif 156 de mesure du courant de mode commun i_{mc}^{∗} décrit en référence à la figure 1.

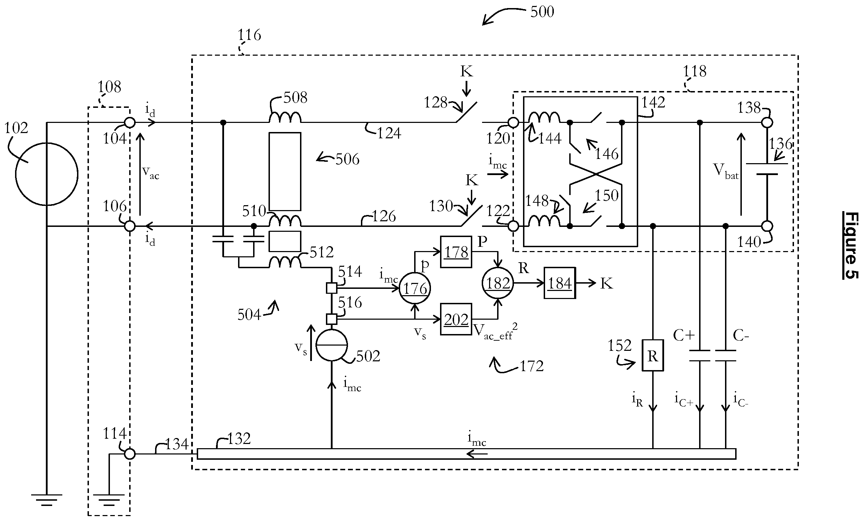

En référence à la figure 5, une cinquième installation de recharge 500 selon l'invention va à présent être décrite.

Dans ce mode de réalisation, le dispositif 172 d'évaluation du défaut d'isolement 152 comporte un générateur 502 du courant de mode commun i_{mc}. Le courant de mode commun i_{mc} généré est alternatif, de préférence à une fréquence supérieure à 50 Hz.

Le dispositif 172 d'évaluation du défaut d'isolement 152 comporte en outre un dispositif 504 pour injecter le courant de mode commun i_{mc} généré par le générateur 502 dans les conducteurs de phase 124 et de neutre 126, en direction des points d'entrée de phase 120 et de neutre 122 du circuit électrique 118.

Dans l'exemple décrit, le dispositif 504 comporte tout d'abord un filtre de mode commun 506 comportant deux inductances de filtrage 508, 510 couplées l'une à l'autre, et montées respectivement sur les conducteurs de phase 124 et de neutre 126. Le filtre de mode commun 506 est destiné à empêcher l'apparition d'un courant de mode commun en provenance du réseau électrique 102.

Le dispositif 504 comporte en outre une inductance d'injection 512 couplée à au moins une des inductances de filtrage 508, 510, et présentant une première extrémité connectée au générateur 502.

Le dispositif 504 comporte en outre deux capacités C1, C2 connectant une deuxième extrémité de l'inductance de filtrage 512 respectivement aux conducteurs de phase 124 et de neutre 126, entre la station de recharge 108 et les inductances de filtrage 508, 510.

Le dispositif 504 comporte en outre un dispositif 514 de mesure du courant de mode commun i_{mc}. Le dispositif 514 comporte par exemple un ampèremètre disposé en entrée ou en sortie du générateur 502, c'est-à-dire à l'une des extrémités du générateur 502.

Le dispositif 504 comporte en outre un dispositif 516 de mesure d'une tension vₛ fournie par le générateur de courant 502.

La mesure du courant de mode commun i_{mc} et la mesure de la tension vₛ sont utilisées pour déterminer la résistance R et/ou une amplitude du courant i_{R}, comme cela est expliqué dans les modes de réalisation précédents.

Le mode de réalisation de la figure 5 présente comme avantage de pouvoir mesurer le défaut d'isolation 152 même lorsque le système électrique 116 n'est pas connecté au réseau électrique 102.

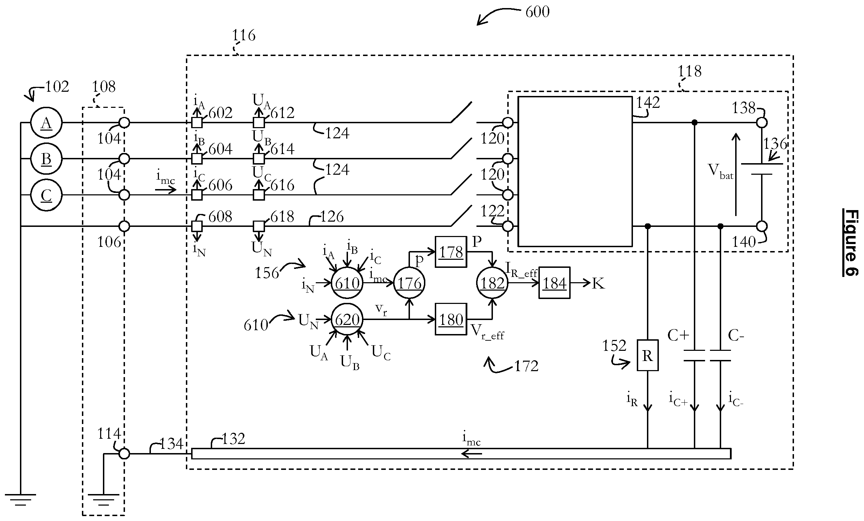

En référence à la figure 6, une sixième installation de recharge 600 selon l'invention va à présent être décrite.

La sixième installation de recharge 600 est similaire à celle de la figure 4, si ce n'est que le réseau 102 est cette fois un réseau triphasé, présentant trois phases A, B, C, et présentant trois bornes de phase 104 dans la station de recharge 108.

Le système électrique 116 comporte ainsi trois conducteurs de phase 124 et le circuit électrique 118 comporte trois points d'entrée de phase 120.

En outre, le dispositif 156 de mesure du courant de mode commun i_{mc} comporte quatre ampèremètres 602, 604, 606, 608 destinés à mesurer les courants i_{A}, i_{B}, i_{C}, i_{N} parcourant respectivement les conducteurs de phase 124 et le conducteur de neutre 126 dans le même sens, par exemple en provenance du réseau électrique 102. Le dispositif 156 comporte en outre un dispositif 610 pour déterminer le courant de mode commun i_{mc} à partir des mesures i_{A}, i_{B}, i_{C}, i_{N} des ampèremètres 602, 604, 606, 608, par exemple en additionnant les courants i_{A}, i_{B}, i_{C}, i_{N} mesurés.

Le dispositif 172 d'évaluation du défaut d'isolation 152 comporte en outre un dispositif 612 pour mesurer une tension résiduelle Vr fournie par le réseau électrique 102. En effet, il peut arriver que les tension U_{A}, U_{B}, U_{C} des phases A, B, C ne soit pas parfaitement équilibrées par rapport à la tension de neutre U_{N}, c'est-à-dire que leur somme n'est pas nulle, mais égale à la tension résiduelle (proportionnelle à la tension homopolaire). C'est cette tension résiduelle Vr, fournie par le réseau électrique 102, provoque l'apparition du courant de mode commun i_{mc}. Dans l'exemple décrit, le dispositif 610 comporte quatre voltmètre 612, 614, 616, 618 pour mesurer les tensions U_{A}, U_{B}, U_{C}, U_{N} respectivement des conducteurs de phase 124 et du conducteur de neutre 126, et un dispositif 620 pour déterminer la tension résiduelle vᵣ à partir des mesure de tension U_{A}, U_{B}, U_{C}, U_{N}, par exemple en additionnant les mesures U_{A}, U_{B}, U_{C} et en soustrayant la mesure U_{N}. La tension vᵣ est ensuite traitée de la même manière que la tension v_{ac} du mode de réalisation de la figure 4 pour déterminer l'amplitude efficace I_{R_eff} du courant i_{R} du défaut d'isolation 152.

La présente invention n'est pas limitée aux modes de réalisation décrits précédemment, mais est au contraire définie par les revendications qui suivent. Il sera en effet apparent à l'homme du métier que des modifications peuvent y être apportées.

Par exemple, dans le cas d'un réseau polyphasé, le dispositif 172 pourrait être destiné à déterminer la tension entre une seule phase et le neutre, pour multiplier cette tension avec le courant de mode commun pour obtenir la puissance p.

Par ailleurs, les termes utilisés dans les revendications ne doivent pas être compris comme limités aux éléments des modes de réalisation décrits précédemment, mais doivent au contraire être compris comme couvrant tous les éléments équivalents que l'homme du métier peut déduire à partir de ses connaissances générales.

## Revendications

1. Système électrique (116) pour un véhicule automobile, ledit système comportant :
- un circuit électrique (118) présentant au moins un point d'entrée de phase (120) et un point d'entrée de neutre (122), une tension de réseau d'un réseau électrique (102) étant destinée à être appliquée entre chaque point d'entrée de phase (120) et le point d'entrée de neutre (122) pour alimenter électriquement le circuit électrique (118),
- une masse électrique (132),
- un dispositif (172) d'évaluation d'un défaut d'isolation (152) entre le circuit électrique (118) et la masse électrique (132),
ledit dispositif (172) d'évaluation d'un défaut d'isolation (152) comportant :
- un dispositif (168 ; 156) de mesure d'un premier courant de mode commun (i_{mc}) entrant dans le circuit électrique (118) par son ou ses points d'entrée de phase (120) et son point de neutre (122) et rebouclant par la masse électrique (132), en particulier au travers du défaut d'isolation (152), le premier courant de mode commun (i_{mc}) étant fourni par un générateur électrique (164 ; 102 ; 502),
- un dispositif (174 ; 302) de mesure d'une tension (v_{cp} ; v_{ac}; vᵣ) fournie par le générateur électrique (164 ; 102 ; 502),
- un dispositif (176) de multiplication de la mesure du premier courant de mode commun (i_{mc}) par la mesure de la tension (v_{cp} ; v_{ac} ; vᵣ) pour obtenir une puissance (p) développée par le générateur électrique (164 ; 102) pour fournir le premier courant de mode commun (i_{mc}),
- un dispositif (178) de détermination d'une partie active (P) de la puissance (p),
- un dispositif (182) de détermination d'au moins une grandeur électrique (R ; I_{R_eff}) représentative du défaut d'isolation (152), à partir de la partie active (P) de la puissance (p),
ledit système électrique (116) comportant en outre :
- au moins un conducteur de phase (124) et un conducteur de neutre (126) présentant des premières extrémités connectées respectivement aux points d'entrée de phase (120) et de neutre (122) du circuit électrique (118), et des deuxièmes extrémités destinées à être connectées respectivement à au moins une borne de phase (104) et une borne de neutre (106) du réseau électrique (102), et
**caractérisé en ce que** ledit système électrique comprend en outre :
- un dispositif (154) d'annulation d'un deuxième courant de mode commun (i_{mc}^{∗}) entrant dans les conducteurs de phase (124) et de neutre (126) par leurs deuxièmes extrémités, comportant :
- un dispositif (156) de mesure du deuxième courant de mode commun (i_{mc}^{∗}),
- un générateur (164), à partir de la mesure du deuxième courant de mode commun (i_{mc}^{∗}), d'un courant de compensation (i_{cp}) s'écoulant depuis la masse électrique (132) vers les conducteurs de phase (124) et de neutre (126), et étant sensiblement égal au premier courant de mode commun (i_{mc}),
dans lequel le générateur (164) du courant de compensation (i_{cp}) est le générateur électrique (164) du dispositif (172) d'évaluation du défaut d'isolation (152).

2. Système électrique (116) selon la revendication 1, dans lequel le dispositif (168) de mesure du premier courant de mode commun (i_{mc}) est destiné à mesurer le courant de compensation (i_{cp}) en tant que mesure du premier courant de mode commun (i_{mc}).

3. Système électrique (116) selon l'une des revendications précédentes, dans lequel le dispositif (174) de mesure de la tension (v_{cp}) générée par le générateur électrique (164) est destiné à mesurer, en tant que mesure de la tension (v_{cp}) générée par le générateur électrique (164), la tension de réseau (v_{ac}) entre le conducteur de phase (124) et le conducteur de neutre (126).

4. Système électrique (116) selon l'une des revendications 1 à 2, dans lequel le dispositif (302) de mesure de la tension (v_{cp}) générée par le générateur électrique (164) est destiné à mesurer une tension de compensation (v_{cp}) fournie par le générateur (164) du courant de compensation (i_{cp}).

5. Système électrique (116) selon l'une des revendications précédentes, dans lequel le générateur électrique (102) est le réseau électrique (102).

6. Système électrique (116) selon la revendication 5, dans lequel le dispositif (156) de mesure du premier courant de mode commun (i_{mc}) est destiné à mesurer le premier courant de mode commun (i_{mc}) à partir des conducteurs de phase (124) et de neutre (126).

7. Système électrique (116) selon la revendication 5 ou 6, dans lequel le réseau électrique (102) est monophasé, et dans lequel le dispositif (174) de mesure de la tension (v_{ac}) générée par le générateur électrique (102) est destiné à mesurer la tension de réseau (v_{ac}) entre le conducteur de phase (124) et le conducteur de neutre (126).

8. Système électrique (116) selon la revendication 1, comportant en outre le générateur électrique (502), et dans lequel le générateur électrique (502) est un générateur de courant destiné à générer le premier courant de mode commun (i_{mc}).

9. Système électrique (116) selon la revendication 8, comportant en outre :
- au moins un conducteur de phase (124) et un conducteur de neutre (126) présentant des premières extrémités connectées respectivement au ou aux points d'entrée de phase (120) et au point d'entrée de neutre (122) du circuit électrique (118), et des deuxièmes extrémités destinées à être connectées respectivement à au moins une borne de phase (104) et une borne de neutre (106) du réseau électrique (102),
et dans lequel le dispositif (172) d'évaluation du défaut d'isolation (152) comporte en outre :
- un dispositif (504) pour injecter le premier courant de mode commun (i_{mc}) dans les conducteurs de phase (124) et de neutre (126), en direction des points d'entrée de phase (120) et de neutre (122) du circuit électrique (118).

10. Système électrique (116) selon la revendication 9, dans lequel le dispositif (504) pour injecter le premier courant de mode commun (i_{mc}) dans les conducteurs de phase (124) et de neutre (126), comporte :
- un filtre de mode commun (506) comportant au moins deux inductances de filtrage (508, 510) montées respectivement sur les conducteurs de phase (124) et de neutre (126), la ou les inductances de filtrage (508) montées sur le ou les conducteurs de phase (124) étant couplées avec l'inductance de filtrage (510) montée sur le conducteur de neutre (126),
- une inductance d'injection (512) couplée à au moins une des inductances de filtrage (508, 510), et présentant une première extrémité connectée au générateur (502) du courant de mode commun,
- deux capacités (C1, C2) connectant une deuxième extrémité de l'inductance d'injection (512) respectivement aux conducteurs de phase (124) et de neutre (126).

11. Système électrique (116) selon l'une quelconque des revendications 1 à 10, dans lequel le circuit électrique (118) comporte :
- une batterie (136) comportant une borne positive (138) et une borne négative (140) et présentant une tension de batterie (V_{bat}) entre ses bornes positive (138) et négative (140), et
- un redresseur de tension (142) connecté, d'un côté, aux points d'entrée de phase (120) et de neutre (122) du circuit électrique (118) et, d'un autre côté, aux bornes positive (138) et négative (140) de la batterie (136), le redresseur de tension (142) étant destiné à convertir la tension de réseau (v_{ac}) en la tension de batterie (V_{bat}), pour recharger la batterie (136) à partir du réseau électrique (102).

12. Véhicule automobile comportant un système électrique (116) selon la revendication 11, dans lequel la masse électrique (132) comporte un châssis du véhicule automobile, et dans lequel la batterie (136) est destinée à alimenter électriquement des organes électriques du véhicule automobile et/ou un moteur d'entraînement de roues motrices du véhicule automobile.

## Patentansprüche

1. Elektrisches System (116) für ein Kraftfahrzeug, das System aufweisend:
- eine elektrische Schaltung (118) mit wenigstens einem Phaseneingangspunkt (120) und einem Neutralleitereingangspunkt (122), wobei eine Netzspannung eines Stromnetzes (102) dazu bestimmt ist, zwischen jedem Phaseneingangspunkt (120) und dem Neutralleitereingangspunkt (122) angelegt zu sein, um die elektrische Schaltung (118) mit Strom zu versorgen,
- eine elektrische Masse (132),
- eine Vorrichtung (172) zur Bewertung eines Isolationsfehlers (152) zwischen der elektrischen Schaltung (118) und der elektrischen Masse (132),
wobei die Vorrichtung (172) zur Bewertung eines Isolationsfehlers (152) Folgendes aufweist:
- eine Vorrichtung (168; 156) zur Messung eines ersten Gleichtaktstroms (i_{mc}), der in die elektrische Schaltung (118) über deren Phaseneingangspunkt(e) (120) und Neutralleiterpunkt (122) eintritt und über die elektrische Masse (132) zurückfließt, insbesondere durch den Isolationsfehler (152), wobei der erste Gleichtaktstrom (i_{mc}) von einem elektrischen Generator (164; 102; 502) bereitgestellt wird,
- eine Vorrichtung (174; 302) zur Messung einer Spannung (v_{cp}; v_{ac}; vᵣ), die vom elektrischen Generator (164; 102; 502) bereitgestellt wird,
- eine Vorrichtung (176) zur Multiplikation der Messung des ersten Gleichtaktstroms (i_{mc}) mit der Messung der Spannung (v_{cp}; v_{ac}; vᵣ), um eine Leistung (p) zu erhalten, die vom elektrischen Generator (164; 102) entwickelt wird, um den ersten Gleichtaktstrom (i_{mc}) bereitzustellen,
- eine Vorrichtung (178) zur Bestimmung eines aktiven Anteils (P) der Leistung (p),
- eine Vorrichtung (182) zur Bestimmung wenigstens einer elektrischen Größe (R; I_{R_eff}), die für den Isolationsfehler (152) repräsentativ ist, ausgehend von dem aktiven Anteil (P) der Leistung (p),
das elektrische System (116) ferner aufweisend:
- wenigstens einen Phasenleiter (124) und einen Neutralleiter (126) mit ersten Enden, die jeweils an die Phasen- (120) bzw. Neutralleitereingangspunkte (122) der elektrischen Schaltung (118) angeschlossen sind, und zweiten Enden jeweils zum Anschluss an wenigstens einen Phasenanschluss (104) bzw. einen Neutralleiteranschluss (106) des Stromnetzes (102), und
**dadurch gekennzeichnet, dass** das elektrische System ferner Folgendes umfasst:
- eine Vorrichtung (154) zur Aufhebung eines zweiten Gleichtaktstroms (i_{mc}^{∗}), der in die Phasen- (124) und Neutralleiter (126) durch deren zweite Enden eintritt, aufweisend:
- eine Vorrichtung (156) zur Messung des zweiten Gleichtaktstroms (i_{mc}^{∗}),
- einen Generator (164), ausgehend von der Messung des zweiten Gleichtaktstroms (i_{mc}^{∗}), eines Ausgleichsstroms (i_{cp}), der von der elektrischen Masse (132) zu den Phasen-(124) und Neutralleitern (126) fließt und im Wesentlichen gleich dem ersten Gleichtaktstrom (i_{mc}) ist,
wobei der Generator (164) des Ausgleichsstroms (i_{cp}) der elektrische Generator (164) der Vorrichtung (172) zur Messung des Isolationsfehlers (152) ist.

2. Elektrisches System (116) nach Anspruch 1, wobei die Vorrichtung (168) zur Messung des ersten Gleichtaktstroms (i_{mc}) dazu bestimmt ist, den Ausgleichsstrom (i_{cp}) als Messung des ersten Gleichtaktstroms (i_{mc}) zu messen.

3. Elektrisches System (116) nach einem der vorhergehenden Ansprüche, wobei die Vorrichtung (174) zur Messung der Spannung (v_{cp}), die vom elektrischen Generator (164) erzeugt wird, dazu bestimmt ist, als Messung der Spannung (v_{cp}), die vom elektrischen Generator (164) erzeugt wird, die Netzspannung (v_{ac}) zwischen dem Phasenleiter (124) und dem Neutralleiter (126) zu messen.

4. Elektrisches System (116) nach einem der Ansprüche 1 bis 2, wobei die Vorrichtung (302) zur Messung der Spannung (v_{cp}), die vom elektrischen Generator (164) erzeugt wird, dazu bestimmt ist, eine Ausgleichsspannung (v_{cp}) zu messen, die vom Generator (164) des Ausgleichsstroms (i_{cp}) bereitgestellt wird.

5. Elektrisches System (116) nach einem der vorhergehenden Ansprüche, wobei der elektrische Generator (102) das Stromnetz (102) ist.

6. Elektrisches System (116) nach Anspruch 5, wobei die Vorrichtung (156) zur Messung des ersten Gleichtaktstroms (i_{mc}) dazu bestimmt ist, den ersten Gleichtaktstrom (i_{mc}) ausgehend von den Phasen- (124) und Neutralleitern (126) zu messen.

7. Elektrisches System (116) nach Anspruch 5 oder 6, wobei das Stromnetz (102) einphasig ist und wobei die Vorrichtung (174) zur Messung der Spannung (v_{ac}), die vom elektrischen Generator (102) erzeugt wird, dazu bestimmt ist, die Netzspannung (v_{ac}) zwischen dem Phasenleiter (124) und dem Neutralleiter (126) zu messen.

8. Elektrisches System (116) nach Anspruch 1, ferner aufweisend den elektrischen Generator (502), und wobei der elektrische Generator (502) ein Stromgenerator ist, der dazu bestimmt ist, den ersten Gleichtaktstrom (i_{mc}) zu erzeugen.

9. Elektrisches System (116) nach Anspruch 8, ferner aufweisend:
- wenigstens einen Phasenleiter (124) und einen Neutralleiter (126) mit ersten Enden, die jeweils am oder an den Phaseneingangspunkt (120) bzw. am Neutralleitereingangspunkt (122) der elektrischen Schaltung (118) angeschlossen sind, und zweiten Enden jeweils zum Anschluss an wenigstens einen Phasenanschluss (104) bzw. einen Neutralleiteranschluss (106) des Stromnetzes (102),
und wobei die Vorrichtung (172) zur Bewertung des Isolationsfehlers (152) ferner Folgendes aufweist:
- eine Vorrichtung (504) zum Injizieren des ersten Gleichtaktstroms (i_{mc}) in die Phasen- (124) und Neutralleiter (126) in Richtung der Phasen- (120) und Neutralleitereingangspunkte (122) der elektrischen Schaltung (118).

10. Elektrisches System (116) nach Anspruch 9, wobei die Vorrichtung (504) zum Injizieren des ersten Gleichtaktstroms (i_{mc}) in die Phasen- (124) und Neutralleiter (126) Folgendes aufweist:
- einen Gleichtaktfilter (506), der wenigstens zwei Filterinduktivitäten (508, 510) aufweist, die jeweils auf den Phasen- (124) und Neutralleitern (126) montiert sind, wobei die Filterinduktivität(en) (508), die auf dem oder den Phasenleitern (124) montiert sind, mit der Filterinduktivität (510) gekoppelt sind, die auf dem Neutralleiter (126) montiert ist,
- eine Injektionsinduktivität (512), die an wenigstens eine der Filterinduktivitäten (508, 510) gekoppelt ist und ein erstes Ende aufweist, das an den Generator (502) des Gleichtaktstroms angeschlossen ist,
- zwei Kapazitäten (C1, C2), die ein zweites Ende der Injektionsinduktivität (512) jeweils mit den Phasen- (124) bzw. Neutralleitern (126) verbinden.

11. Elektrisches System (116) nach einem der Ansprüche 1 bis 10, wobei die elektrische Schaltung (118) Folgendes aufweist:
- eine Batterie (136) mit einem positiven Anschluss (138) und einem negativen Anschluss (140) und einer Batteriespannung (V_{bat}) zwischen ihrem positiven (138) und negativen Anschluss (140), und
- einen Spannungsgleichrichter (142), der einerseits an die Phasen- (120) und Neutralleitereingangspunkte (122) der elektrischen Schaltung (118) und auf einer anderen Seite an den positiven (138) und negativen Anschluss (140) der Batterie (136) angeschlossen ist, wobei der Spannungsgleichrichter (142) dazu bestimmt ist, die Netzspannung (v_{ac}) in die Batteriespannung (V_{bat}) umzuwandeln, um die Batterie (136) aus dem Stromnetz (102) wieder aufzuladen.

12. Kraftfahrzeug aufweisend ein elektrisches System (116) nach Anspruch 11, wobei die elektrische Masse (132) einen Rahmen des Kraftfahrzeugs umfasst und wobei die Batterie (136) dazu bestimmt ist, elektrische Elemente des Kraftfahrzeugs und/oder einen Motor zum Antrieb von Antriebsrädern des Kraftfahrzeugs mit Strom zu versorgen.

## Claims

1. Electrical system (116) for a motor vehicle, said system comprising:
- an electrical circuit (118) having at least one phase input point (120) and a neutral input point (122), a grid voltage from an electrical grid (102) being intended to be applied between each phase input point (120) and the neutral input point (122) so as to supply electrical power to the electrical circuit (118),
- an electrical ground (132),
- a device (172) for evaluating an insulation fault (152) between the electrical circuit (118) and the electrical ground (132),
said device (172) for evaluating an insulation fault (152) comprising:
- a device (168; 156) for measuring a first common-mode current (i_{mc}) entering the electrical circuit (118) via its phase input point or points (120) and its neutral point (122) and looping back via the electrical ground (132), in particular through the insulation fault (152), the first common-mode current (i_{mc}) being supplied by an electrical generator (164; 102; 502),
- a device (174; 302) for measuring a voltage (v_{cp}; v_{ac}; vᵣ) supplied by the electrical generator (164; 102; 502),
- a device (176) for multiplying the measurement of the first common-mode current (i_{mc}) by the measurement of the voltage (v_{cp}; v_{ac}; vᵣ) so as to obtain a power (p) that is delivered by the electrical generator (164; 102) so as to supply the first common-mode current (i_{mc}),
- a device (178) for determining an active part (P) of the power (p),
- a device (182) for determining, from the active part (P) of the power (p), at least one electrical quantity (R; I_{R_eff}) that is representative of the insulation fault (152),
said electrical system (116) further comprising:
- at least one phase conductor (124) and a neutral conductor (126) having first ends that are respectively connected to the phase input and neutral input points (120, 122) of the electrical circuit (118), and second ends that are intended to be respectively connected to at least one phase terminal (104) and a neutral terminal (106) of the electrical grid (102), and
**characterized in that** said electrical system further comprises:
- a device (154) for cancelling out a second common-mode current (i_{mc}^{∗}) entering the phase and neutral conductors (124, 126) via their second ends, comprising:
- a device (156) for measuring the second common-mode current (i_{mc}^{∗}),
- a generator (164), from the measurement of the second common-mode current (i_{mc}^{∗}), of a compensation current (i_{cp}) flowing from the electrical ground (132) to the phase and neutral conductors (124, 126), and being substantially equal to the first common-mode current (i_{mc}),
in which the generator (164) of the compensation current (i_{cp}) is the electrical generator (164) of the device (172) for evaluating the insulation fault (152).

2. Electrical system (116) according to Claim 1, wherein the device (168) for measuring the first common-mode current (i_{mc}) is intended to measure the compensation current (i_{cp}) as the measurement of the first common-mode current (i_{mc}) .

3. Electrical system (116) according to either of the preceding claims, wherein the device (174) for measuring the voltage (v_{cp}) generated by the electrical generator (164) is intended to measure, as the measurement of the voltage (v_{cp}) generated by the electrical generator (164), the grid voltage (v_{ac}) between the phase conductor (124) and the neutral conductor (126).

4. Electrical system (116) according to either of Claims 1 and 2, wherein the device (302) for measuring the voltage (v_{cp}) generated by the electrical generator (164) is intended to measure a compensation voltage (v_{cp}) supplied by the generator (164) of the compensation current (i_{cp}) .

5. Electrical system (116) according to one of the preceding claims, wherein the electrical generator (102) is the electrical grid (102).

6. Electrical system (116) according to Claim 5, wherein the device (156) for measuring the first common-mode current (i_{mc}) is intended to measure the first common-mode current (i_{mc}) from the phase and neutral conductors (124, 126).

7. Electrical system (116) according to Claim 5 or 6, wherein the electrical grid (102) is single-phase, and wherein the device (174) for measuring the voltage (v_{ac}) generated by the electrical generator (102) is intended to measure the grid voltage (v_{ac}) between the phase conductor (124) and the neutral conductor (126).

8. Electrical system (116) according to Claim 1, further comprising the electrical generator (502), and wherein the electrical generator (502) is a current generator intended to generate the first common-mode current (i_{mc}).

9. Electrical system (116) according to Claim 8, further comprising:
- at least one phase conductor (124) and a neutral conductor (126) having first ends that are respectively connected to the phase input point or points (120) and to the neutral input point (122) of the electrical circuit (118), and second ends that are intended to be respectively connected to at least one phase terminal (104) and a neutral terminal (106) of the electrical grid (102),
and wherein the device (172) for evaluating the insulation fault (152) further comprises:
- a device (504) for injecting the first common-mode current (i_{mc}) into the phase and neutral conductors (124, 126), in the direction of the phase input and neutral input points (120, 122) of the electrical circuit (118).

10. Electrical system (116) according to Claim 9, wherein the device (504) for injecting the first common-mode current (i_{mc}) into the phase and neutral conductors (124, 126) comprises:
- a common-mode filter (506) comprising at least two filtering inductors (508, 510) respectively installed on the phase and neutral conductors (124, 126), the filtering inductor or inductors (508) installed on the phase conductor or conductors (124) being coupled with the filtering inductor (510) installed on the neutral conductor (126),
- an injection inductor (512) coupled to at least one of the filtering inductors (508, 510), and having a first end that is connected to the generator (502) of the common-mode current,
- two capacitors (C1, C2) connecting a second end of the injection inductor (512) to the phase and neutral conductors (124, 126), respectively.

11. Electrical system (116) according to any one of Claims 1 to 10, wherein the electrical circuit (118) comprises:
- a battery (136) comprising a positive terminal (138) and a negative terminal (140) and having a battery voltage (V_{bat}) between its positive and negative terminals (138, 140), and
- a voltage rectifier (142) that is connected, on one side, to the phase input and neutral input points (120, 122) of the electrical circuit (118) and, on another side, to the positive and negative terminals (138, 140) of the battery (136), the voltage rectifier (142) being intended to convert the grid voltage (v_{ac}) into the battery voltage (V_{bat}) so as to recharge the battery (136) from the electrical grid (102).

12. Motor vehicle comprising an electrical system (116) according to Claim 11, wherein the electrical ground (132) comprises a chassis of the motor vehicle, and wherein the battery (136) is intended to supply electrical power to electrical components of the motor vehicle and/or a motor for powering drive wheels of the motor vehicle.
